(19) Europäisches Patentamt / European Patent Office / Office européen des brevets

(11) **EP 3 775 943 B1**

(12) **EUROPEAN PATENT SPECIFICATION**

(45) Date of publication and mention
of the grant of the patent:
**06.09.2023  Bulletin 2023/36**

(21) Application number: **19716992.3**

(22) Date of filing: **27.03.2019**

(51) International Patent Classification (IPC):
**G01R 22/06** $^{(2006.01)}$

(52) Cooperative Patent Classification (CPC):
**G01R 22/066**

(86) International application number:
**PCT/IB2019/052490**

(87) International publication number:
**WO 2019/186422 (03.10.2019 Gazette 2019/40)**

(54) **A MONITORING AND PROTECTION DEVICE**

ÜBERWACHUNGS- UND SCHUTZVORRICHTUNG

DISPOSITIF DE SURVEILLANCE ET DE PROTECTION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **28.03.2018  GB 201804995**

(43) Date of publication of application:
**17.02.2021  Bulletin 2021/07**

(73) Proprietor: **Kamata Online Protection Services (KOPS) Limited
Kamwokya - Kampala (UG)**

(72) Inventors:
• **AIJUKA, Edmand
Kamwokya - Kampala (UG)**

• **MUTEBI, Ibrahim
Kamwokya - Kampala (UG)**

(74) Representative: **O'Connor, Michael Donal
O'Connor Intellectual Property
Suite 207, Q House
Furze Road
Sandyford, Dublin 18 (IE)**

(56) References cited:
**EP-A1- 0 897 116      WO-A1-2013/187747
GB-A- 357 221         GB-A- 2 280 290
US-A- 5 422 565       US-A1- 2004 150 384**

## Description

### Technical Field:

This invention relates to a monitoring and protection device for detecting attempted theft of electricity. More specifically, the present invention relates to a monitoring and protection device that may be used in conjunction with a number of disparate types of electricity meters that is operable to detect attempts to circumvent the electricity meter and steal electricity from an electricity provider.

### Background Art:

Electricity theft is a significant problem for electricity providers. Not only does the theft of electricity typically represent a substantial financial loss for the electricity provider, it also impacts the tariff, increasing the cost of electricity for paying customers. Accordingly, it is highly desirable to detect and prevent attempts at theft of electricity and revenue protection is a key priority for utilities.

Unfortunately, electricity theft is common worldwide, but is particularly prevalent in developing countries where the electricity network is relatively primitive and attempts at electricity theft can be difficult to detect. An additional problem arises when the electricity provider's staff is complicit in the theft of electricity and actually engage and assist the customer in the theft of electricity.

Asset monitoring is also a big challenge for electricity companies with incomplete and sometimes no records of their assets. Meters are stolen, replaced, moved to different locations, experience faults, are bypassed, opened to add extra objects, stop functioning and sometimes get lost within the system.

Many solutions have been proposed to obviate the problems of electricity theft. For example smart metering technology, cameras and automatic meter readers are just some of the existing solutions that have been proposed. The smart meters may more closely monitor the electricity usage of their customers and anomalous activity may be detected and investigated if necessary. However, this solution is not entirely satisfactory as smart meters are relatively expensive and necessitate the upgrade of the entire existing metering infrastructure which is very costly. Furthermore, smart meters are unable to detect and report bypasses outside of the meter or identify foreign bodies installed in the meter to slow or stop the meter.

United States Patent Application Publication Number US2004/0150384 in the name of Holle discloses a smart meter. The smart meter has a service disconnect switch and a voltage sense circuit. In addition, the smart meter has a processing circuit operable to generate a tamper flag based on the output of the voltage sense circuit Although useful, the meter requires replacement of the existing metering arrangement and therefore increases the capital cost of implementing such an offering on a wide scale.

WO2013/187747 (in the name of Zvirblis) discloses a protection module for preventing unauthorized use of electric energy. EP0897116 (in the name of ITF-EDV Froeschl GmbH) discloses a system for monitoring utility meters. GB2280290 (in the name of Siemens Measurements Limited) discloses a commodity metering apparatus. GB357,221 (in the name of Georges De Frescheville) discloses an apparatus for preventing the withdrawal of current from the mains side of a consumers current meter. US5422565 discloses a method and system for sensing removal of a utility meter from its socket.

It is an object of the present invention to provide a monitoring and protection device that overcomes at least some of the above-mentioned problems. It is a further object of the present invention to provide a solution that is simple and cost-effective to implement. In particular, it is an object of the invention to provide a device that is separate and distinct from a meter and that can be used in conjunction with existing infrastructure without requiring replacement of existing metering technology with so-called smart meters or the like. It is a further still object of the present invention to provide a solution that provides a useful alternative choice to the electricity provider.

### Summary of Invention:

According to the invention there is provided a monitoring and protection device for detecting attempted theft of electricity comprising a housing having:

a plurality of connection points including at least one input connection point and at least one output connection point each for connection to an electricity line to allow placement of the monitoring and protection device in series with an electricity meter and a circuit breaker on the electricity line;

a switching component;

a current sensing device;

a first voltage sensing device intermediate the switching component and the output connection point;

a communication module for communications with a remote control unit;

a central processing unit (CPU) having a memory with programmed instructions thereon, the CPU being in communication with the switching component, the current sensing device, the voltage sensing device and the communication module, the CPU being operable to actuate the switching component in response to a control instruction received from the remote control unit or upon detection of an anomalous electricity line condition.

By having such a monitoring and protection device, the monitoring and protection device may be used in conjunction with a number of disparate types of existing meters (both prepaid and post-paid) for use in the detection of electricity fraud. Importantly, it is not necessary to replace the existing meters with so-called smart meters in order to detect the electricity fraud. Furthermore, the monitoring and protection device can detect the meter location and health in advance of failure, and report interference in near real time. Importantly, the monitoring and protection device may be used to detect if the meter has stopped working, the meter is faulty, has lost accuracy over time, if fraudulent extra discrete component(s) have been added on its circuit board, if it has been entirely removed from the installation site or if the meter is being bypassed within or outside the meter box.

This represents a significant advantage for the electricity provider as heretofore it was not possible for the electricity provider to determine whether the meter was being bypassed or faulty without conducting a physical inspection using on-site personnel. Once fraudulent activity is detected, the supply of electricity may be cut off without delay in many cases and further loss prevented. A further advantage of the monitoring and protection device of the present invention is that the monitoring and protection device may be used to cut off or reinstate electricity to the premises. This may be done without a technician being present at the premises.

In one embodiment of the invention there is provided a monitoring and protection device in which there is provided a tamper detection circuit to detect tampering of the housing and in which the CPU is operable to actuate the switching component in response to the tamper detection circuit detecting a tampering attempt. In this way, if an attempt to interfere with the monitoring and protection device is detected, the supply of electricity can be cut off immediately with or without manual intervention. An unauthorized access notification is automatically sent to the remote control unit.

In one embodiment of the invention there is provided a monitoring and protection device in which there is provided a meter enclosure tamper detection circuit to detect tampering of a meter enclosure, and in which the CPU is operable to actuate the switching component in response to the meter enclosure tamper detection circuit detecting a tampering attempt. This is seen as a particularly preferred embodiment of the present invention. By having such a configuration, once the monitoring and protection device has been installed, it may monitor the enclosure that the meter is housed in and if an unauthorized attempt is made to access that enclosure for illegal purposes, the monitoring and protection device may be operated to cut off the electricity supply to the premises.

In one embodiment of the invention there is provided a monitoring and protection device in which the meter enclosure tamper detection circuit comprises a mechanical tamper switch. This is seen as a very simple and inexpensive device to use in the detection of a third party attempting to access the meter enclosure.

In one embodiment of the invention there is provided a monitoring and protection device in which the meter enclosure tamper detection circuit comprises an ambient light sensor. This is seen as a very effective way to detect a third party attempting to access the enclosure. The light sensor may be an infra-red sensor. Once the enclosure is opened, the light incident on the sensor will change and this change may be detected as an indicator that the enclosure has been opened. The monitoring and protection device can then be operated without delay to cut off the electricity supply to the premises.

In one embodiment of the invention there is provided a monitoring and protection device in which there is provided a pulse picking sensor. A pulse picking sensor is seen as a useful way of detecting whether the electricity meter in the premises is faulty, if extra discrete components have been added on to the meter circuit board to slow it down, if the electricity meter has been entirely bypassed leaving it out of the circuit or has been tampered with. The pulse picking sensor can monitor one or more electricity usage light emitting diodes (LEDs) on the electricity meter and compare the results with the values measured and calculated using the current sensor and voltage sensor of the monitoring and protection device along with other detection equipment if desired. Any discrepancy between the value observed by the pulse picking sensor and the detected value may be indicative of fraudulent activity which is then communicated to the cloud based remote monitoring software in real time.

In one embodiment of the invention there is provided a monitoring and protection device in which the current sensing device comprises a current transformer. This is seen as a simple and effective device for use as the current sensing device.

In one embodiment of the invention there is provided a monitoring and protection device in which the current sensing device comprises a shunt. This is also seen as a useful and inexpensive device for use in current sensing.

In one embodiment of the invention, the switching component comprises a relay device. In another embodiment of the invention, the switching component comprises a controllable circuit breaker. A relay will work well for single phase meters and 100A three phase devices whereas the controllable circuit breaker is deemed more appropriate for 200A, 400A and 800A (three phase) configurations.

In one embodiment of the invention there is provided a second voltage sensing device, the second voltage sensing device being located intermediate the relay switch and the input connection point. By having a pair of voltage sensing devices, this is seen as particularly useful configuration to detect blackout conditions as the value of the first voltage sensing device upstream of the switching component may be compared with the value of the second voltage sensing device downstream of the switching component when the switching component is open or closed. By having the voltage both upstream of the switching component given by the first voltage sensing device and downstream of the switching component, it is possible to determine if the meter has been bypassed by looping a conductor (current carrying cable) in parallel to the electricity meter. If the switching component is opened and a voltage is detected at the second sensing device then this will be an indication of a fraudulent voltage only transmitted by the looping conductor. This attempt will be communicated to the remote monitoring software in real time. Furthermore, the monitoring and protection device will be able to detect the removal of a looping conductor and this can also be communicated back to the remote control unit.

In one embodiment of the invention there is provided a monitoring and protection device in which the communications module for communications with a remote control unit comprises a global packet radio service (GPRS) module. Alternatively, the communications module could comprise one of an Internet of Things (IoT) module, a Radio frequency (RF) communication module, a power line carrier (PLC) communication module or a global service for mobile communication (GSM) communication module. By an Internet of Things (IoT) module, what is meant is a communication module that is configured for communication using one of the IoT communication protocols, such as, but not solely limited to any one of Bluetooth, ZigBee, WiFi and LPWAN.

In one embodiment of the invention there is provided a monitoring and protection device in which the voltage sensing device comprises a voltage transformer.

In one embodiment of the invention there is provided a monitoring and protection device in which the monitoring and protection device is located on the electricity line intermediate the electricity meter and the circuit breaker. This is a particularly useful configuration for monitoring single phase installations.

In one embodiment of the invention there is provided a monitoring and protection device configured for connection to multiple users, each with a different circuit having a meter that are monitored and controlled by a single monitoring and protection device, the single monitoring and protection device having a plurality of inputs, a plurality of outputs, a plurality of switching components, a plurality of current sensing devices and a plurality of voltage sensing devices, in which at least one input, at least one output, one of the current sensing devices, at least one of the voltage sensing devices and one of the switching components is dedicated to each of the circuits to be monitored. It is envisaged that some of the components of the monitoring and protection device may be shared between the different circuits including for example, one or more of the power supply to the electronic circuitry of the monitoring and protection device, the central processing unit and the communications module.

In one embodiment of the invention there is provided a monitoring and protection device in which the device is provided with means to measure the actual voltage, current and power values of load consumption; means to capture the metered values of voltage, current and power; and means to compare those actual values with the metered values. The means to capture the metered values may be by way of a connection through a serial port to the meter or may be through monitoring of an LED array on the meter or through other means if desired.

In one embodiment of the invention, there is provided means to monitor the instantaneous current in each of the three phases of a three-phase electricity supply. In another embodiment of the invention, there is provided means to monitor the instantaneous current in the neutral line of a three-phase electricity supply. By monitoring the instantaneous current in each of the phases of a three-phase supply, the instantaneous currents may thereafter be summed together and used to determine whether or not there is a bypass in the supply line. Under normal operating parameters, the sum of the instantaneous current in the three phases should equal zero. If the sum of the three instantaneous currents does not equal zero, this is indicative that there is a bypass in the circuit. This is seen as particularly useful for detecting a bypass in a Delta-Wye configuration.

In one embodiment of the invention there is provided a monitoring and protection system comprising: a monitoring and protection device as claimed in any preceding claim; and a remote control unit in communication with the monitoring and protection device, the remote control unit comprising a remote controlling and monitoring software program that communicates to the central processing unit through the communication module, the remote controlling and monitoring software program having a user interface through which commands can be initiated and executed at the remote monitoring and protection device.

**Brief Description of the Drawings:**

The invention will now be more clearly understood from the following description of some embodiments thereof given by way of example only with reference to the accompanying drawings, in which:-

Figures 1(a) to 1(e) are diagrammatic representations of disparate attempts at electricity fraud;

Figure 2 is a diagrammatic representation of the placement of the monitoring and protection device according to the invention relative to an existing meter;

Figure 3 is a circuit schematic of a first embodiment of monitoring and protection device according to the invention;

Figure 4 is a circuit schematic of a second embodiment of monitoring and protection device according to the invention;

Figure 5 is a view similar to Figure 2 showing the placement of the monitoring and protection device according to the invention in conjunction with a prepaid electricity meter;

Figure 6 is a diagrammatic view showing the placement of the monitoring and protection device according to the invention in use simultaneously with multiple electricity meters;

Figure 7 is a diagrammatic view showing the placement of the monitoring and protection device according to the invention in a three-phase system;

Figure 8 is a diagrammatic view showing a further attempt at electricity fraud in a three phase system;

Figure 9 is a circuit schematic of a third embodiment of monitoring and protection device according to the invention; and

Figure 10 is a diagrammatic representation of a monitoring and protection system according to the invention.

**Detailed Description of the Drawings:**

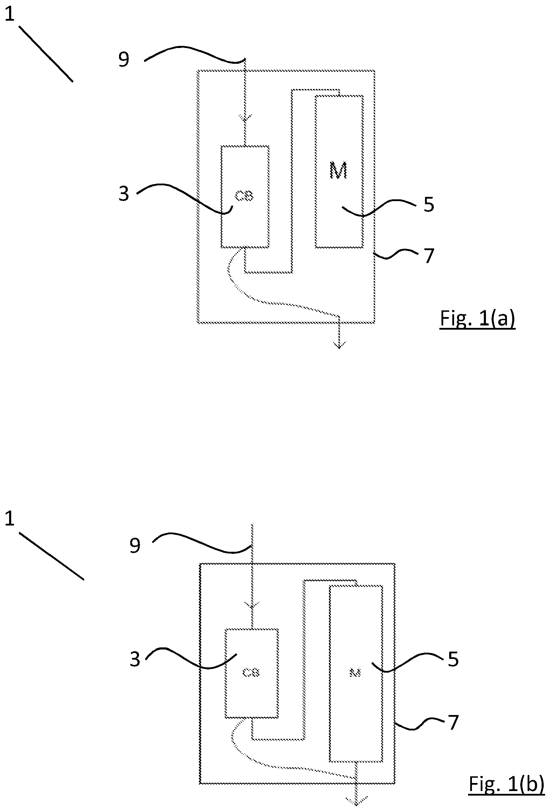

Referring to the drawings and initially to Figures 1(a) to 1(e) inclusive, there is shown a number of circuit configurations commonly used to steal electricity from an electricity provider. The electricity installation, indicated generally by the reference numeral 1, comprises a circuit breaker 3 and an electricity meter 5 housed inside a meter enclosure 7. Under normal operation, an electricity cable 9 is fed from the mains supply network to the circuit breaker 3 and from there the electricity feed is thereafter supplied to the customer via the electricity meter 5. The electricity meter 5 monitors the amount of electricity flowing therethrough so that the customer may be billed appropriately periodically for their electricity usage.

Referring specifically to Figure 1(a), there is shown a full loop in-box bypass arrangement. In this arrangement, the electricity cable 9 exiting the circuit breaker inside the meter enclosure is split in two and the electricity cable 9 is supplied directly to the output, circumventing the meter inside the meter enclosure. In this configuration, the electricity meter is looped entirely and the electricity meter 5 will not record any of the energy consumed by the client.

Referring to Figure 1(b), there is shown a partial in-box loop. In this arrangement, the electricity cable exiting the circuit breaker inside the meter enclosure is split in two and the portion of the electricity cable that is split off from the rest of the electricity cable is rejoined to the electricity cable that has passed through the electricity meter. In this way, the electricity meter 5 will count some, albeit less than the actual amount of electricity consumed by the client.

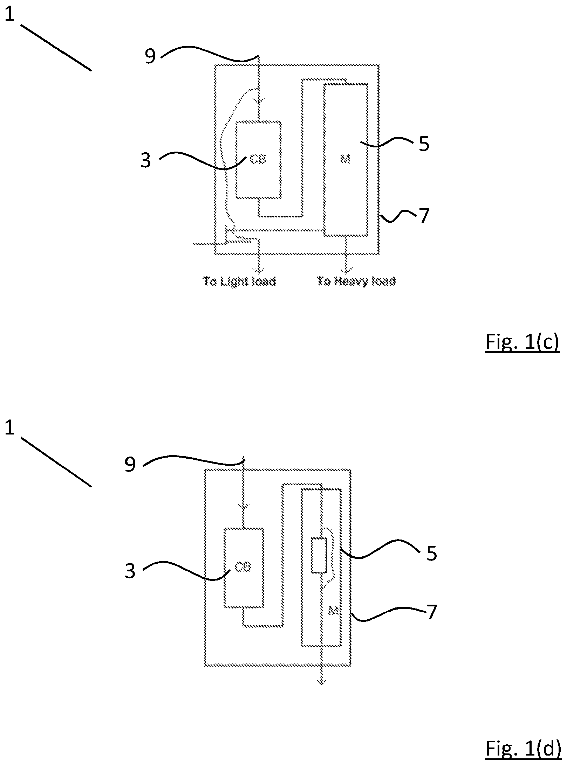

Referring to Figure 1(c), there is shown a phase neutral mismatch configuration for theft of electricity. In this arrangement, the circuit breaker 3 and the electricity meter 5 are both partially circumvented by splitting the live electricity cable 9 upstream of the circuit breaker and using that line on a neutral line (not shown) of the electricity supply. That neutral line is then used to power some, although usually not all, electrical equipment (not shown) in the premises. In this way, the electricity meter 5 will register less energy than the actual consumed electricity in the premises.

Referring to Figure 1(d), there is shown a tampered meter configuration for theft of electricity. In this arrangement, the electricity meter 5 has been modified by adding an object, typically a resistor of some sort, such as a resistor configured in parallel to the normal load in the electricity meter, to slow down the electricity meter so that the electricity meter 5 registers less electricity usage in the premises than the actual consumed electricity.

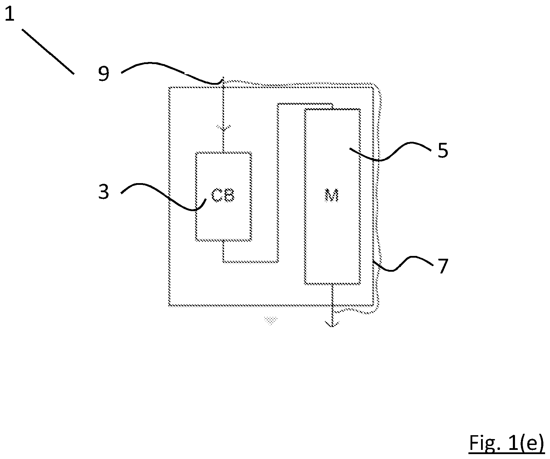

Referring to Figure 1(e), there is shown a full loop out-box bypass arrangement. In this configuration, the entire meter enclosure 7 including the circuit breaker 3 and the electricity meter 5 have been bypassed. The electrical supply cable is split before reaching the meter enclosure and is spliced back onto the electrical supply cable exiting the meter enclosure. In this way, the same cable normally used for electricity supply in the premises can be used for electrical supply and the amount of metered electricity is minimal. The configurations illustrated in Figures 1(a) to 1(e) inclusive are all common ways in which electricity may be stolen and it is an object of the present invention to provide a monitoring and protection device that can identify at least one, but preferably all of these configurations.

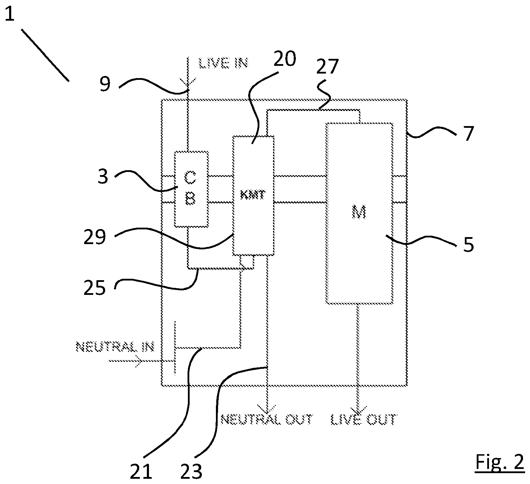

Referring now to Figure 2 of the drawings, there is shown a diagrammatic representation of the placement of the monitoring and protection device according to the invention, indicated generally by the reference numeral 20, relative to an existing meter 5 in a meter enclosure 7. The monitoring and protection device 20 is placed in line (i.e. in series) between the circuit breaker 3 and the electricity meter 5 inside the existing meter enclosure 7. The monitoring and protection device 20 has a neutral in terminal 21, a neural out terminal 23, a live in terminal 25 and a live out terminal 27. The live in terminal 25 is fed from the circuit breaker 3 and the live out terminal is fed directly to the electricity meter 5 input. The monitoring and protection device 20 comprises a substantially sealed housing 29 in which the electronic circuitry is housed.

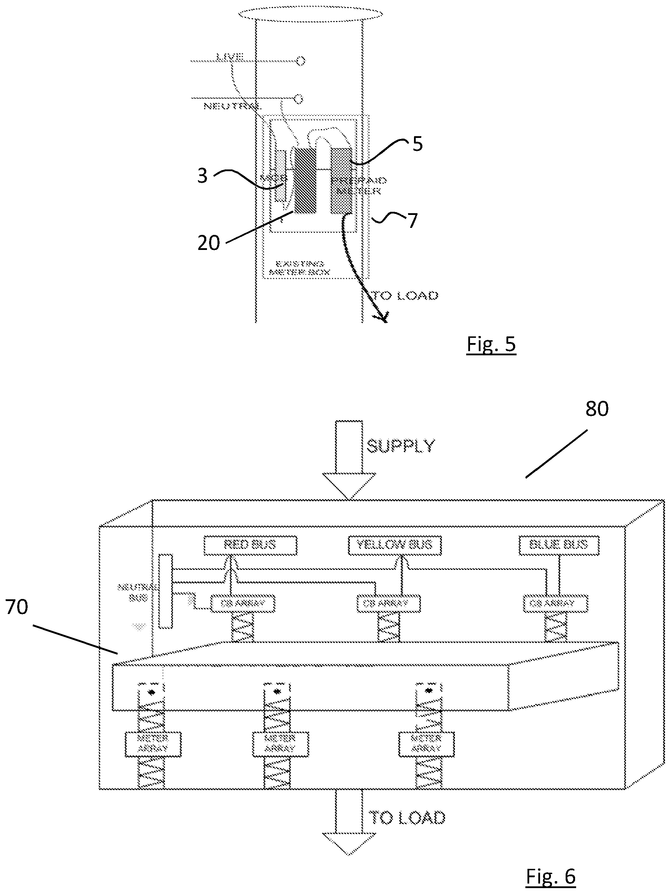

Referring now to Figure 5, there is shown a view similar to Figure 2 showing the placement of the monitoring and protection device 20 according to the invention in conjunction with a pre-paid electricity meter, in this case on a single phase supply. It will be understood that the monitoring and protection device according to the present invention works with both single phase and three phase arrangements to good effect.

Referring now to Figure 6, there is shown a diagrammatic view showing the placement of the monitoring and protection device 70 according to the invention in use simultaneously with multiple electricity meters, all of which are housed in a common enclosure 80. The monitoring and protection device 70 may monitor the electricity meter enclosure 80 and the electricity supply may or may not be interrupted using a relay in the case of fraud being detected.

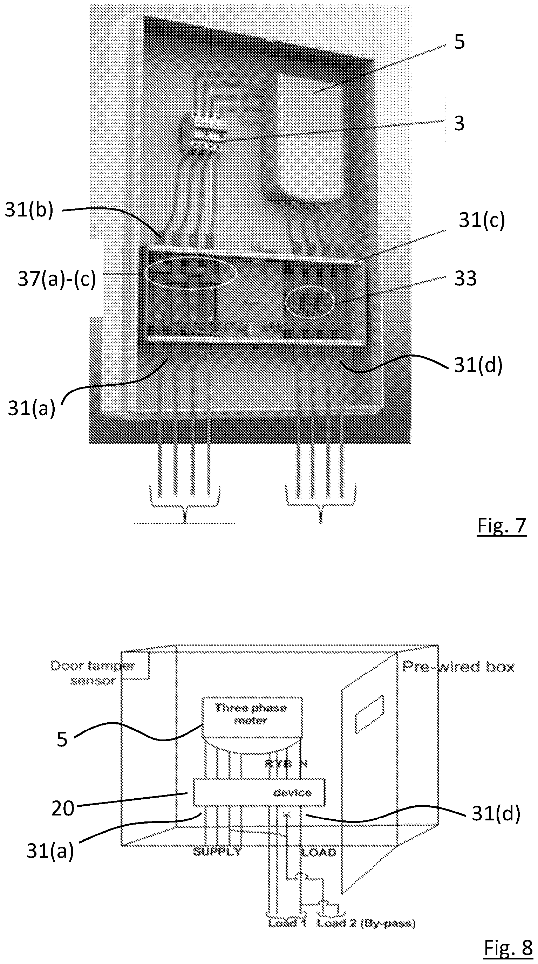

Referring now to Figure 7, there is shown a diagrammatic view showing the placement of an embodiment of the invention in a three phase system, where like parts have been given the same reference numeral as before. The three phases and neutral lines are fed in at an input 31(a) of the monitoring and protection device 20 and pass through monitoring equipment 37(a)-(c) before passing through output 31(b) and onwards to a circuit breaker 3. From there, the electricity passes to the meter 5. Having passed through the meter 5, the electricity flows back to the monitoring and protection device 20 through the connection points 31(c) and to the switching components 33 before exiting the monitoring and detection device 20 at connection points 31(d) where it proceeds to the load (not shown).

In the embodiment shown in Figure 7, the circuit breaker 3 is positioned intermediate the monitoring and protection device 20 and the meter 5, downstream of the output 31(b) and upstream of the meter 5. As an alternative, the circuit breaker could be positioned upstream of the monitoring and protection device 20 so that the incoming electrical cabling passes through the circuit breaker 3 first, then to the input 31(a) of the monitoring and protection device 20, from the output 31(b) of the monitoring and protection device 20 to the meter 5, and from the meter 5 is delivered back to the connection points 31(c) of the monitoring and protection device 20 and thereafter to the switching components 33 before exiting the monitoring and protection device 20 at connection points 31(d) where it proceeds to the load (not shown). In single phase versions, the incoming electrical cabling will first pass through the circuit breaker before passing into the monitoring and protection device 20.

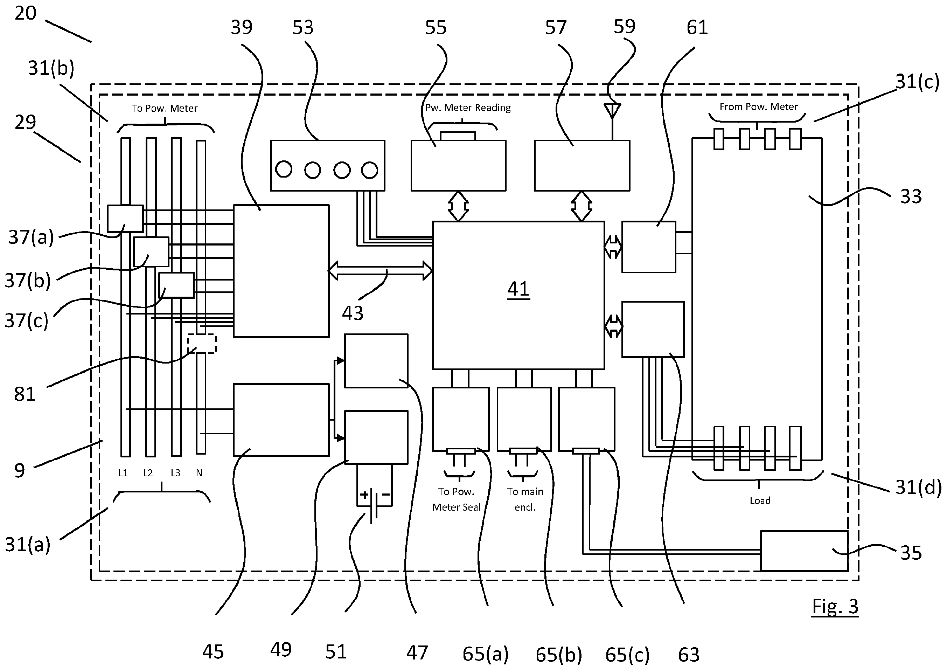

Referring now to Figure 3, there is shown a circuit schematic of the first embodiment of monitoring and protection device 20 according to the invention. The monitoring and protection device 20 comprises a casing 29 housing a plurality of connection points 31(a)-31(d). Connection points 31(a) are connected to each of the phases of the three phase 240V AC input and the neutral of the 240V AC input. Connection points 31(b) are the continuation of those phases and neutral lines and are connected in turn to the circuit breaker (not shown) and then to the electrical power meter (not shown). Connection points 31(c) comprise the three phases and neutral returning from the power meter to the power relay 33 and connection points 31(d) are the three phase and neutral connections passed onwards to the load (not shown) in the premises. The precise configuration is described in more detail with reference to Figure 7.

The monitoring and protection device further comprises a point 35 for a tamper switch. The tamper switch 35 is connected intermediate the circuitry and the casing 29 of the monitoring and protection device to detect if the casing 29 has been opened. A second tamper switch (not shown) is connected onto the cover that encloses the electricity meter, the circuit breaker and the device and is connected to tamper detection circuit 65(b). In this way, the relay may be operated and an alert may be sent to a remote monitoring station (which will be described in more detail below). The electronic circuitry of the monitoring and protection device further comprises a plurality of current transformers 37(a), 37(b) and 37(c), one of which is located on each of the phases of the incoming electricity supply cable 9. The current transformers 37(a)-37(c) are in turn connected up to a measurement circuit 39 in which the voltage, current, energy, phase drift and other parameters may be measured and monitored before feeding the desired information onwards to a central processing unit (CPU) 41 over a communication bus 43. There is further provided an AC/DC converter 45 (in this case a 240V AC to 5V DC converter) for powering the circuitry from the incoming mains feed (prior to metering). The AC/DC converter 45 is in turn connected to a DC/DC converter 47 (in this case a 5V DC to 3.3V DC converter) that is able to provide the necessary supply voltage for at least some of the circuitry on the monitoring and protection device and the AC/DC converter is also connected to a battery charger 49 which in turn is connected to a battery 51.

The CPU 41 is further connected to LED array 53 for demonstrating various conditions of the monitoring and protection device such as, but not limited to, the current power supply (i.e. mains or battery), the status of a communications module, the status of the relay 33 and the like. In addition, the CPU 41 is connected to a power meter interface circuit 55, a GPRS communication module 57 having an antenna 59, a relay driving circuit 61, a voltage measuring circuit 63 and a plurality of tamper detection circuits 65(a), 65(b) and 65(c). One of the tamper detection circuits 65(a) is for monitoring the power meter 5 seal, another of the tamper detection circuits 65(b) is for monitoring the meter enclosure 7 and the third tamper detection circuit 65(c) is connected to the tamper switch 35 used to monitor the monitoring and protection device housing 29. The relay driving circuit 61 is in turn connected to the relay 33 and the voltage measuring circuit 63 is operable to measure the voltage at the load output connection points 31(d). The power meter interface circuit 55 comprises optical sensors directed at and used to monitor the power LEDs (not shown) on the electricity meter 5. In this way, the actual power used and the power usage displayed by the electricity meter 5 can be compared to determine if the meter has been interfered with. Furthermore, by measuring the voltage after the relay, the relay may be switched and if there is a voltage detected after the relay, this is a clear indication that the electricity meter has been looped.

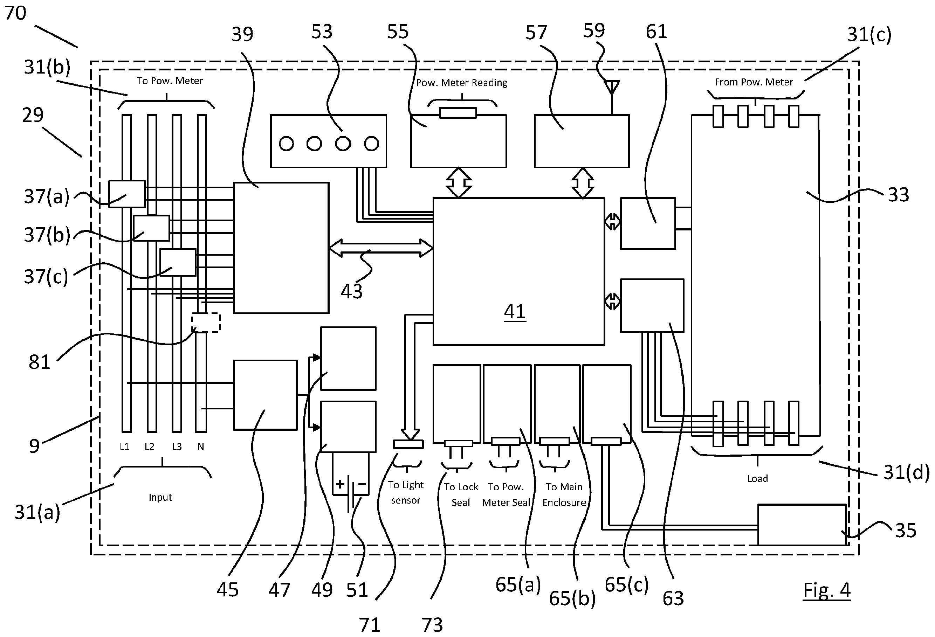

Referring to Figure 4, there is shown a circuit schematic of a second embodiment of monitoring and protection device according to the invention, indicated generally by the reference numeral 70, where like parts have been given the same reference numeral as before. The monitoring and protection device 70 differs from the monitoring and protection device 20 in that there is further provided a connection from the CPU to a tamper detection circuit 71 comprising a light sensor (not shown) and there is provided an additional tamper detection circuit 73 for connection to a lock seal (not shown). The light sensor may be an infra-red sensor operable to detect when the main meter enclosure 9 has been opened. If the light incident on the infra-red sensor changes, this is indicative of the casing being opened and unauthorised activity such a tampering with the meter or monitoring and protection device taking place.

In the embodiments shown in Figures 3 and 4, the energy measuring circuit 39 is provided by way of a Atmel (Registered Trade Mark ®) M90E36A which has seven independent $2^{nd}$ order sigma-delta Analog to Digital Converters (ADCs), an embedded Digital Signal Processor (DSP) to execute the calculation of active energy, reactive energy, apparent energy, fundamental and harmonic active energy over ADC signal and on-chip reference voltage. The DSP also calculates measurement parameters such as voltage and current root-mean-square (RMS) values as well as mean active/reactive/apparent power values. The M90E36A can use current transformers or Rogowski coils in current sampling. For the Rogowski coils, a PA3202NL model could be used to good effect. For the CPU, one suitable device is the STMicro® STM32L151 chip. A flash memory for storage of program instructions could be provided by way of a Winbond® W25Q64F chip and the GPRS module could be provided by way of a Telit ® GE865-Quad chip connected to a Taoglas ® PA.25 antenna. The above are provided by way of example only and it will be readily understood that other components providing the same or similar functionality could be provided instead to good effect. An alternative or additional chip that may be provided for assisting in the measurement and manipulation of the instantaneous current values is the MAXQ3183 chip provided by Maxim Integrated ® having its headquarters in San Jose, California.

In use, the various sensors (e.g. the infra-red and the mechanical tamper switch sensors) monitor whether or not the casings are being interfered with and the voltage and current sensors (as well as phase and/or power monitoring sensors if desired) monitor the parameters of the electricity being supplied through the meter and to the load. Other sensors (e.g. the optical sensors monitoring the power LEDs of the electricity meter) detect how the electricity meter is recording the usage of electricity.

For example, a pulse picking sensor may be installed on top of the energy meter pulsing LED. The meter LED flashes at a rate indicated by the meter constant (which constant typically varies from meter to meter). The pulse picking sensor picks up the pulses from this meter flashing LED and it directly feeds the pulses into the analog input of the CPU. The CPU (Microprocessor) interprets these pulses based on the meter constant which is provided to the CPU. As mentioned, different meters have different meter constants so to implement this on multiple meters from different manufacturers, this meter constant has to be provided to the meter from a remote control station or alternatively a plurality of meter constants for different meters may be stored in CPU memory and the appropriate meter constant may be selected upon installation. The interpreted pulses provide the energy registered by the meter which is then compared to the energy which is recorded by the current and voltage sensors in the monitoring and protection devices. If the two energy values are not the same, then this is indicative of fraud and the CPU would send a command to trip the relay. Advantageously, the pulse picking sensors can be installed on both active or reactive energy indicating electricity meter LEDs. Some manufacturers have these energies combined in one LED but with a pattern that can be interpreted by the CPU and the pulse picking sensor.

If any of the sensors detect anomalous activity, such as the casing being opened or the current and voltage sensing devices determining that there is more power being consumed than being registered by the electricity meter, this will be determined by the CPU and the CPU will operate the relay to cut off electricity and will send an alert to the remote control unit operated by the electricity provider. The electricity provider can then investigate further and appropriate warnings may be issued or penalties may be applied to the customer. The remote control unit that is that is in communication with the communication module of the monitoring and protection device may take several forms. For example, the remote control unit may be a computer running appropriate software in a control centre operated by the electricity provider or indeed the remote control unit may comprise a cloud based software application accessible through a number of disparate devices.

In some cases, the switching element may not be operated. For example, if there are multiple feeds off the electricity supply, such as in an apartment building, it may be inappropriate to shut off electricity to the entire installation and instead, the electricity provider may decide to continue to supply electricity but will investigate further and potentially cut supply to the premises stealing the electricity only. In other cases, such as in the case of a total bypass of the meter enclosure being detected, it may be futile to operate the relay as the relay will not have the desired effect of cutting off the electricity to the premises. In those cases, the electricity provider can investigate the matter further by sending out an investigative team and it is up to the operator whether or not they operate the relay. The investigative team may cut off the power at a substation or other point upstream of the premises where the electricity is being stolen.

Referring now to Figure 8, there is shown one manner in which an individual may attempt to circumvent the monitoring and protection device 20 described above. According to the description of the preceding embodiments, it will be understood that the monitoring and protection device 20 can detect if there is a by-pass between the input to the monitoring and control device, the meter and the output of the monitoring and control device by momentarily opening a relay, measuring the voltage before and after the relay, and if a voltage exists after the relay when the relay is open, then it must have been transmitted by a bypassing conductor. This detected voltage is evidence of a looping bypass conductor.

However, another potential scenario is a bypass in which the customer disconnects the output conductor (of one or two phases) from the output terminals of the monitoring and control device 20. In the embodiment shown in Figure 8, only one of the phases has been disconnected from the output terminals of the monitoring and control device. In this scenario, when the relay is opened, the voltage sensing device at the output terminal will indicate that the voltage at the terminal is zero (normal conditions) because the conductor has been disconnected from the terminal. In this way, the bypass cannot be detected by the detection of an anomalous voltage value at the output.

However, the above bypass attempt can be detected by providing an additional current transformer on the input neutral line (CT_N) (indicated by the reference numeral 81 in Figures 3 and 4). The additional current transformer 81 is located adjacent to the current transformers 37(a)-37(c) inclusive. For a three phase system, the neutral current is proportional to the other currents in the three phases (Red, Yellow and Blue). Having the current transformers 37(a), 37(b) and 37(c) on all three phases, the current going through each phase is measured. The current in the neutral line is also measured by the current transformer 81 on the neutral line. The current measured in the neutral line should be equal to the calculated (expected) neutral current. The formula of the relationship of the three phase currents and the neutral current, $I_N$ is:

$$I_N = \sqrt{((I_R^2 + I_Y^2 + I_B^2) - (I_R * I_Y) - (I_Y * I_B) - (I_B * I_R))}$$

Where

    $I_R$-Root mean square current in the red phase (as read by 37(a))
    $I_Y$-Root mean square current in the red phase (as read by 37(b))
    $I_B$-Root mean square current in the red phase (as read by 37(c))
    $I_N$-Root mean square current in the Neutral (as read by current transformer 81)

If the measured value of neutral current, $I_N$, does not equal the calculated value of neutral current, $I_{C.T(neutral)}$, i.e. if $I_N \neq I_{C.T\ (neutral)}$, then there is a by-pass current in the system not being measured, and an alert may be sent to the remote control unit.

In addition to the foregoing, in certain configurations, it is deemed advantageous to measure and sum the instantaneous currents in the three phase system. If the sum of the instantaneous currents does not equal zero, this is indicative that there is a bypass. This is particularly effective in a Delta-Wye configuration where a bypass may otherwise be difficult to detect.

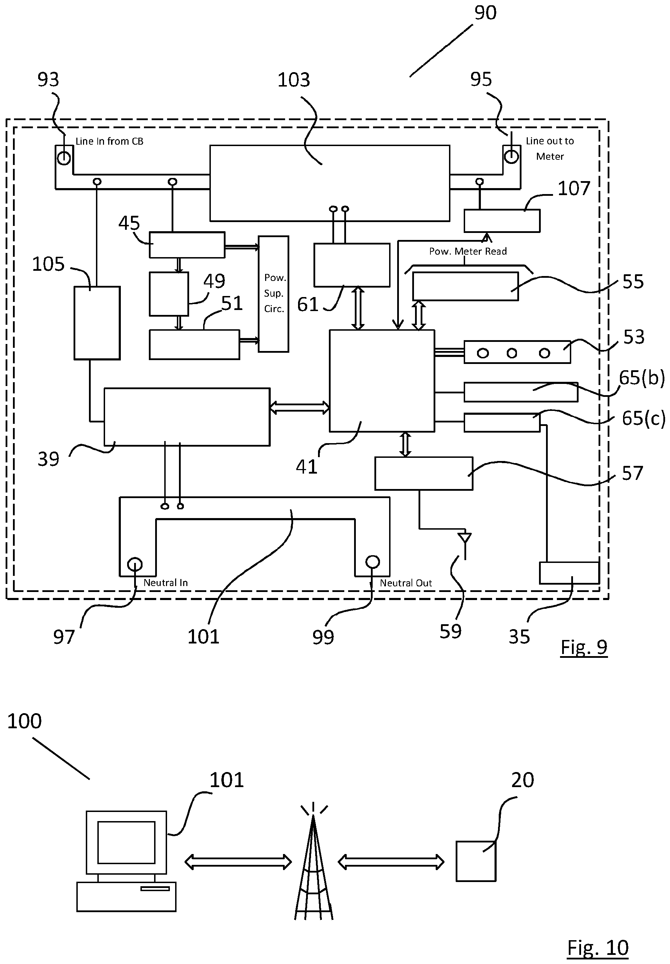

Referring now to Figure 9, there is shown a diagrammatic representation of a third embodiment of monitoring and protection device, indicated generally by the reference numeral 90, suitable for use with a single phase supply, where like parts have been given the same reference numeral as before. The monitoring and protection device 90 is positioned in series between the circuit breaker (not shown) and the electricity meter (not shown) and comprises a live input 93 connected from the circuit breaker and a live output 95 connected to the meter. There is further provided a neutral input 97 and neutral output 99 for connection to a neutral line and that are connected by way of a neutral shunt 101. The power relay 103 comprises a single phase 100A rated power relay. A voltage sensing circuit 105 is provided to monitor the line voltage at the input and a voltage sensing circuit 107 is provided to monitor the line voltage at the output.

In use, the operation of the device is similar to the embodiments hereinbefore described in that the monitoring and protection device 90 will monitor the conditions on the line and detect anomalous conditions. Upon an anomalous condition being detected that is indicative of electricity theft, an alert will be sent to a remote control unit so that the electricity provider can take appropriate action.

It will be understood that the monitoring and protection device according to the invention may be provided in a number of different versions with component rated appropriately for the amount of current and/or voltage that they will be operating with. For example, it is envisaged that there may at least be different versions based on the current ratings of 100 Amperes (which works on direct connected meters), 200:5 Amperes (which works current transformer connected meters of 200/5A), 400:5 Amperes (which works current transformer connected meters of 400/5A) and 800A (which works current transformer connected meters of 800/5A).

Referring now to Figure 10, there is shown a monitoring and protection system, indicated generally by the reference numeral 100, comprising a monitoring and protection device (20, 70, 90) and a remote control unit 101 in communication with the monitoring and protection device. In use, the monitoring and protection device receives instructions from the remote control unit 101 to, for example, open or close the relay as appropriate.

Throughout the specification, reference is made to the monitoring and protection device (20, 70, 90) being positioned in series with the circuit breaker and the existing meter. It will be understood that in some instances, the monitoring and protection device will be arranged so that some of the components will be configured in series between the circuit breaker and the meter and other components may be configured in series with the circuit breaker and the meter downstream of the circuit breaker and the meter. In those cases where there are some components of the monitoring and protection device located in series in different locations relative to the circuit breaker and or the meter, it will be understood that the monitoring and protection device will still be considered to be arranged in series with the other components.

In this specification the terms "comprise, comprises, comprised and comprising" and the terms "include, includes, included and including" are all deemed totally interchangeable and should be give the widest possible interpretation.

The invention is not limited solely to the embodiments hereinbefore described but may be varied in both construction and detail within the scope of the appended claims.

## Claims

1. A monitoring and protection device (20, 70, 90) for detecting attempted theft of electricity comprising a housing (29) having:

   a plurality of connection points including at least one input connection point (31(a)) and at least one output connection point (31(d)) each for connection to an electricity line to allow placement of the monitoring and protection device in series with an electricity meter and a circuit breaker on the electricity line;
   a switching component (33);
   a current sensing device (37(a), 37(b), 37(c));
   **characterized in that** there is provided:

   a first voltage sensing device (63) intermediate the switching component and the output connection point;
   a communication module (57) for communications with a remote control unit;
   a central processing unit (CPU) (41) having a memory with programmed instructions thereon, the CPU being in communication with the switching component (33), the current sensing device (37(a), 37(b), 37(c)), the voltage sensing device (63) and the communication module (57), the CPU (41) being operable to actuate the switching component in response to a control instruction received from the remote control unit or upon detection of an anomalous electricity line condition.

2. A monitoring and protection device (20, 70, 90) as claimed in claim 1 in which there is provided a tamper detection circuit (35, 65(c)) to detect tampering of the housing and in which the CPU is operable to actuate the switching component in response to the tamper detection circuit detecting a tampering attempt.

3. A monitoring and protection device (20, 70, 90) as claimed in claim 1 or 2 in which there is provided a meter enclosure tamper detection circuit 65(a) to detect tampering of a meter enclosure, and in which the CPU (41) is operable to actuate the switching component in response to the meter enclosure tamper detection circuit detecting a tampering attempt.

4. A monitoring and protection device (20, 70, 90) as claimed in claim 3 in which the meter enclosure tamper detection circuit (65(a)) comprises a mechanical tamper switch.

5. A monitoring and protection device (20, 70, 90) as claimed in claim 3 or 4 in which the meter enclosure tamper detection circuit (65(a)) comprises an ambient light sensor.

6. A monitoring and protection device (20, 70, 90) as claimed in any preceding claim in which there is provided a pulse picking sensor.

7. A monitoring and protection device (20, 70, 90) as claimed in any preceding claim in which the current sensing device comprises a current transformer.

8. A monitoring and protection device (20, 70, 90) as claimed in any preceding claim in which the current sensing device comprises a shunt.

9. A monitoring and protection device (20, 70, 90) as claimed in any preceding claim in which there is provided a second voltage sensing device (39), the second voltage sensing device being located intermediate the relay switch (33) and the input connection point (31(a)).

10. A monitoring and protection device (20, 70, 90) as claimed in any preceding claim in which the communications module (57) for communications with a remote control unit comprises a global packet radio service (GPRS) module.

11. A monitoring and protection device (20, 70, 90) as claimed in any of claims 1 to 9 in which the communications module for communications with a remote control unit comprises a one of: (i) an Internet of Things (IoT) module; (ii) a Radio frequency (RF) communication module; (iii) a power line carrier (PLC) communication module; and (iv) a global service for mobile communication (GSM) communication module.

12. A monitoring and protection device (20, 70, 90) as claimed in any preceding claim in which the voltage sensing device comprises a voltage transformer.

13. A monitoring and protection device (20, 70, 90) as claimed in any preceding claim in which the switching device comprises a relay switch.

14. A monitoring and protection device (20, 70, 90) as claimed in any of claims 1 to 12 in which the switching device comprises a controllable circuit breaker.

15. A monitoring and protection device (20, 70, 90) as claimed in claim 1 in which the monitoring and protection device is located on the electricity line intermediate the electricity meter (5) and the circuit breaker (3).

16. A monitoring and protection device (20, 70, 90) as claimed in any preceding claim in which the device is provided with means to measure the actual voltage, current and power values of load consumption; means to capture the metered values of voltage, current and power; and means to compare those actual values with the metered values.

17. A monitoring and protection device (20, 70, 90) as claimed in any preceding claim in which there is provided a current sensing device (37(a), 37(b), 37(c)) on each phase of a multi-phase line and a current sensing device (81) on the neutral line.

18. A monitoring and protection system (100) comprising:

a monitoring and protection device (20, 70, 90) as claimed in any preceding claim;
a remote control unit (101) in communication with the monitoring and protection device, the remote control unit comprising a remote controlling and monitoring software program that communicates to the central processing unit through the communication module, the remote controlling and monitoring software program having a user interface through which commands can be initiated and executed at the remote monitoring and protection device.

**Patentansprüche**

1. Überwachungs- und Schutzvorrichtung (20, 70, 90) zum Erkennen eines versuchten Diebstahls von Elektrizität, die eine Umhüllung (29) umfasst, die Folgendes aufweist:

eine Vielzahl von Anschlusspunkten, die mindestens einen Eingangsanschlusspunkt (31(a)) und mindestens einen Ausgangsanschlusspunkt (31(d)) jeweils zur Verbindung mit einer Elektrizitätsleitung enthalten, um zu ermöglichen, dass die Überwachungs- und Schutzvorrichtung mit einem Elektrizitätszähler und einem Trennschalter an der Elektrizitätsleitung in Reihe geschaltet wird;
ein Schaltelement (33);
eine Stromerfassungsvorrichtung (37(a), 37(b), 37(c)); **dadurch gekennzeichnet, dass** Folgendes vorgesehen ist:

eine erste Spannungserfassungsvorrichtung (63) zwischen dem Schaltelement und dem Ausgangsanschlusspunkt;
ein Kommunikationsmodul (57) für Kommunikationen mit einer Fernsteuereinheit;
eine Zentraleinheit (CPU) (41), die einen Speicher mit programmierten Anweisungen darin aufweist, wobei die CPU mit dem Schaltelement (33), der Stromerfassungsvorrichtung (37(a), 37(b), 37(c)), der Spannungserfassungsvorrichtung (63) und dem Kommunikationsmodul (57) kommuniziert, wobei die CPU (41) betriebsfähig ist, um das Schaltelement als Reaktion auf eine von der Fernsteuereinheit empfangene Steueranweisung oder nach der Erkennung eines anormalen Elektrizitätsleitungszustands zu betätigen.

2. Überwachungs- und Schutzvorrichtung (20, 70, 90) nach Anspruch 1, wobei eine Manipulationserkennungsschaltung (35, 65(c)) zum Erkennen von Manipulationen der Umhüllung vorgesehen ist und wobei die CPU betriebsfähig ist, um das Schaltelement als Reaktion darauf, dass die Manipulationserkennungsschaltung einen Manipulationsversuch erkennt, zu betätigen.

3. Überwachungs- und Schutzvorrichtung (20, 70, 90) nach Anspruch 1 oder 2, wobei eine Zählergehäusemanipulationserkennungsschaltung 65(a) zum Erkennen von Manipulationen eines Zählergehäuses vorgesehen ist und wobei die CPU (41) betriebsfähig ist, um das Schaltelement als Reaktion darauf, dass die Zählergehäusemanipulationserkennungsschaltung einen Manipulationsversuch erkennt, zu betätigen.

4. Überwachungs- und Schutzvorrichtung (20, 70, 90) nach Anspruch 3, wobei die Zählergehäusemanipulationserkennungsschaltung (65(a)) einen Schalter für mechanische Manipulationen umfasst.

5. Überwachungs- und Schutzvorrichtung (20, 70, 90) nach Anspruch 3 oder 4, wobei die Zählergehäusemanipulationserkennungsschaltung (65(a)) einen Umgebungslichtsensor umfasst.

6. Überwachungs- und Schutzvorrichtung (20, 70, 90) nach einem vorhergehenden Anspruch, wobei ein Impulsaufnahmesensor vorgesehen ist.

7. Überwachungs- und Schutzvorrichtung (20, 70, 90) nach einem vorhergehenden Anspruch, wobei die Stromerfassungsvorrichtung einen Stromwandler umfasst.

8. Überwachungs- und Schutzvorrichtung (20, 70, 90) nach einem vorhergehenden Anspruch, wobei die Stromerfassungsvorrichtung einen Shunt umfasst.

9. Überwachungs- und Schutzvorrichtung (20, 70, 90) nach einem vorhergehenden Anspruch, wobei eine zweite Spannungserfassungsvorrichtung (39) vorgesehen ist, wobei die zweite Spannungserfassungsvorrichtung zwischen den Relaisschalter (33) und den Eingangsanschlusspunkt (31(a)) geschaltet ist.

10. Überwachungs- und Schutzvorrichtung (20, 70, 90) nach einem vorhergehenden Anspruch, wobei das Kommunikationsmodul (57) für Kommunikationen mit einer Fernsteuereinheit ein Global-Packet-Radio-Service-Modul (GPRS-Modul) umfasst.

11. Überwachungs- und Schutzvorrichtung (20, 70, 90) nach einem der Ansprüche 1 bis 9, wobei das Kommunikationsmodul für Kommunikationen mit einer Fernsteuereinheit eines von Folgendem umfasst: (i) einem Internet-of-Things-Modul (IoT-Modul); (ii) einem Hochfrequenz-Kommunikationsmodul (HF-Kommunikationsmodul); (iii) einem Power-Line-Carrier-Kommunikationsmodul (PLC-Kommunikationsmodul); und (iv) einem Global-Service-for-Mobile-Communication-Kommunikationsmodul (GSM-Kommunikationsmodul).

12. Überwachungs- und Schutzvorrichtung (20, 70, 90) nach einem vorhergehenden Anspruch, wobei die Spannungserfassungsvorrichtung einen Spannungswandler umfasst.

13. Überwachungs- und Schutzvorrichtung (20, 70, 90) nach einem vorhergehenden Anspruch, wobei die Schaltvorrichtung einen Relaisschalter umfasst.

14. Überwachungs- und Schutzvorrichtung (20, 70, 90) nach einem der Ansprüche 1 bis 12, wobei die Schaltvorrichtung einen steuerbaren Trennschalter umfasst.

15. Überwachungs- und Schutzvorrichtung (20, 70, 90) nach Anspruch 1, wobei die Überwachungs- und Schutzvorrichtung an der Elektrizitätsleitung zwischen den Elektrizitätszähler (5) und den Trennschalter (3) geschaltet ist.

16. Überwachungs- und Schutzvorrichtung (20, 70, 90) nach einem vorhergehenden Anspruch, wobei die Vorrichtung mit Einrichtungen zum Messen der Spannungs-, Strom- und Leistungsistwerte eines Lastverbrauchs, Einrichtungen zum Aufnehmen der Spannungs-, Strom- und Leistungsmesswerte und Einrichtungen zum Vergleichen dieser Istwerte mit den Messwerten ausgestattet ist.

17. Überwachungs- und Schutzvorrichtung (20, 70, 90) nach einem vorhergehenden Anspruch, wobei eine Stromerfassungsvorrichtung (37(a), 37(b), 37(c)) an jeder Phase einer Mehrphasenleitung und eine Stromerfassungsvorrichtung (81) an der Neutralleitung vorgesehen ist.

18. Überwachungs- und Schutzsystem (100), das Folgendes umfasst:

    eine Überwachungs- und Schutzvorrichtung (20, 70, 90) nach einem vorhergehenden Anspruch;
    eine Fernsteuereinheit (101), die mit der Überwachungs- und Schutzvorrichtung kommuniziert, wobei die Fernsteuereinheit ein Fernsteuerungs- und

    - überwachungssoftwareprogramm, das durch das Kommunikationsmodul mit der Zentraleinheit kommuniziert, umfasst, wobei das Fernsteuerungs- und
    - überwachungssoftwareprogramm eine Benutzerschnittstelle, durch die Befehle ausgelöst und an der Fernüberwachungs- und -schutzvorrichtung ausgeführt werden können, aufweist.

**Revendications**

1. Dispositif de surveillance et de protection (20, 70, 90) pour détecter une tentative de vol d'électricité comprenant un boîtier (29) présentant :

une pluralité de points de raccordement comportant au moins un point de raccordement d'entrée (31(a)) et au moins un point de raccordement de sortie (31(d)) servant chacun au raccordement à une ligne électrique afin de permettre le placement du dispositif de surveillance et de protection en série avec un compteur d'électricité et un disjoncteur sur la ligne électrique ;
un composant de commutation (33) ;
un dispositif de détection de courant (37(a), 37(b), 37(c)) ; **caractérisé en ce que** sont fournis :

un premier dispositif de détection de tension (63) entre le composant de commutation et le point de connexion de sortie ;
un module de communication (57) pour des communications avec une unité de commande à distance ;
une unité centrale de traitement (CPU) (41) présentant une mémoire avec des instructions programmées, la CPU étant en communication avec le composant de commutation (33), le dispositif de détection de courant (37(a), 37(b), 37(c)), le dispositif de détection de tension (63) et le module de communication (57), la CPU (41) étant exploitable pour actionner le composant de commutation en réponse à une instruction de commande reçue à partir de l'unité de commande à distance ou à la détection d'un état de ligne électrique anormal.

2. Dispositif de surveillance et de protection (20, 70, 90) selon la revendication 1 dans lequel est fourni un circuit de détection de manipulation (35, 65(c)) pour détecter une manipulation du boîtier et dans lequel la CPU est exploitable pour actionner le composant de commutation en réponse à la détection d'une tentative de manipulation par le circuit de détection de manipulation.

3. Dispositif de surveillance et de protection (20, 70, 90) selon la revendication 1 ou 2 dans lequel est fourni un circuit de détection d'effraction d'enceinte de compteur 65(a) pour détecter une effraction d'une enceinte de compteur, et dans lequel la CPU (41) est exploitable peut actionner le composant de commutation en réponse à la détection d'une tentative d'effraction par le circuit de détection d'effraction d'enceinte de compteur.

4. Dispositif de surveillance et de protection (20, 70, 90) selon la revendication 3 dans lequel le circuit de détection d'effraction d'enceinte de compteur (65(a)) comprend un interrupteur anti-effraction mécanique.

5. Dispositif de surveillance et de protection (20, 70, 90) selon la revendication 3 ou 4 dans lequel le circuit de détection d'effraction d'enceinte de compteur (65(a)) comprend un capteur de lumière ambiante.

6. Dispositif de surveillance et de protection (20, 70, 90) selon l'une quelconque des revendications précédentes dans lequel est fourni un capteur de prélèvement d'impulsions.

7. Dispositif de surveillance et de protection (20, 70, 90) selon l'une quelconque des revendications précédentes dans laquelle le dispositif de détection de courant comprend un transformateur de courant.

8. Dispositif de surveillance et de protection (20, 70, 90) selon l'une quelconque des revendications précédentes dans lequel le dispositif de détection de courant comporte un shunt.

9. Dispositif de surveillance et de protection (20, 70, 90) selon l'une quelconque des revendications précédentes dans lequel est fourni un second dispositif de détection de tension (39), le second dispositif de détection de tension étant placé entre l'interrupteur de relais (33) et le point de connexion d'entrée (31 (a)).

10. Dispositif de surveillance et de protection (20, 70, 90) selon l'une quelconque des revendications précédentes dans lequel le module de communication (57) pour les communications avec une unité de commande à distance comprend un module de service global de radiocommunication par paquets (GPRS).

11. Dispositif de surveillance et de protection (20, 70, 90) selon l'une quelconque des revendications 1 à 9 dans lequel le module de communication pour les communications avec une unité de commande à distance comprend un des modules suivants : (i) un module de l'Internet des objets (IoT) ; (ii) un module de communication par radiofréquence (RF); (iii) un module de communication par courants porteurs en ligne (PLC); et (iv) un module de communication du service mondial de communication mobile (GSM).

12. Dispositif de surveillance et de protection (20, 70, 90) selon l'une quelconque des revendications précédentes dans lequel le dispositif de détection de tension comprend un transformateur de tension.

13. Dispositif de surveillance et de protection (20, 70, 90) selon l'une quelconque des revendications précédentes dans laquelle le dispositif de commutation comprend un commutateur relais.

14. Dispositif de surveillance et de protection (20, 70, 90) selon l'une quelconque des revendications 1 à 12 dans lequel le dispositif de commutation comprend un disjoncteur contrôlable.

15. Dispositif de surveillance et de protection (20, 70, 90) selon la revendication 1 dans lequel le dispositif de surveillance et de protection est situé sur la ligne électrique entre le compteur d'électricité (5) et le disjoncteur (3).

16. Dispositif de surveillance et de protection (20, 70, 90) selon l'une quelconque des revendications précédentes dans lequel le dispositif est muni de moyens pour mesurer les valeurs réelles de tension, de courant et de puissance de consommation de la charge ; de moyens de saisie des valeurs mesurées de tension, de courant et de puissance; et des moyens de comparaison de ces valeurs réelles aux valeurs mesurées.

17. Dispositif de surveillance et de protection (20, 70, 90) selon l'une quelconque des revendications précédentes dans lequel sont fournis un dispositif de détection de courant (37(a), 37(b), 37(c)) sur chaque phase d'une ligne multiphasée et un dispositif de détection de courant (81) sur la ligne neutre.

18. Système de surveillance et de protection (100) comprenant :

un dispositif de surveillance et de protection (20, 70, 90) selon l'une quelconque des revendications précédentes ;
une unité de commande à distance (101) en communication avec le dispositif de surveillance et de protection, l'unité de commande à distance comprenant un logiciel de commande et de surveillance à distance qui communique avec l'unité centrale de traitement par l'intermédiaire du module de communication, le logiciel de commande et de surveillance à distance présentant une interface utilisateur par le biais de laquelle des commandes peuvent être émises et exécutées au niveau du dispositif de surveillance et de protection à distance.

Fig. 1(a)

Fig. 1(b)

1

9

3  CB

5

M

7

To Light load    To Heavy load

Fig. 1(c)

1

9

3  CB

5

M

7

Fig. 1(d)

Fig. 1(e)

1

9  LIVE IN  20  27

7

3  C
B

29  KMT

25

M

5

NEUTRAL IN

21  23  NEUTRAL OUT  LIVE OUT

Fig. 2

Fig. 3

EP 3 775 943 B1

Fig. 4

Fig. 5

Fig. 6

Fig. 7

Fig. 8

Fig. 9

Fig. 10

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20040150384 A
- WO 2013187747 A
- EP 0897116 A
- GB 2280290 A
- GB 357221 A
- US 5422565 A